# EUROPÄISCHE PATENTSCHRIFT

(11) **EP 2 388 910 B1**
(45) Veröffentlichungstag und Bekanntmachung des Hinweises auf die Patenterteilung: **09.11.2016**
(21) Anmeldenummer: 11000926.3
(22) Anmeldetag: 05.02.2011
(51) Int. Cl.: H03F 1/02

(54) **Elektronische Schaltung mit durch einen Schaltbetriebsverstärker unterstütztem Linearverstärker**
Electronic switch with a linear amplifier supported by a switching amplifier
Commutation électronique dotée d'un dispositif de renforcement linéaire assisté par un dispositif de renforcement en mode commuté

(30) Priorität: 17.05.2010 CH 7612010
(43) Veröffentlichungstag der Anmeldung: 23.11.2011
(73) Patentinhaber: ETEL S.A., 2112 Môtiers (CH)
(72) Erfinder: Froidevaux, Claude, 2300 La Chaux-de-Fonds (CH); Vaucher, Jean-Marc, 2108 Couvet (CH)
(74) Vertreter: Pleyer, Hans Anno

(56) Entgegenhaltungen:
- WO-A2-03/038985
- GB-A- 2 070 373
- US-A1- 2002 089 316
- US-A1- 2008 265 822
- US-B1- 6 219 262

## Beschreibung

Die vorliegende Erfindung betrifft eine elektronische Schaltung, die eine Linearverstärkereinheit umfasst, die durch eine Schaltbetriebs-Verstärkungseinheit unterstützt ist.

Ein präziser Leistungslinearverstärker kann in verschiedenen elektronischen Anwendungen verwendet werden, wie beispielsweise für die Steuerung eines Elektromotors. Da es im Allgemeinen keine Welligkeit am Ausgang eines derartigen Linearverstärkers gibt, besitzt er auch einen sehr guten Rauschabstand (SNR). Stromwelligkeiten sind nämlich ein Nachteil einer elektronischen Schaltung, wenn diese insbesondere für die Steuerung eines Elektromotors für eine sehr präzise Positionierung verwendet wird, da die durch diese Welligkeiten erzeugten Schwingungen zu einem Verlust der Positionierungspräzision führen. Dazu wird eine Steuerspannung, die eine Gleichspannung sein kann, an den Eingang des Linearverstärkers angelegt, um einen bestimmten Strom über eine Last am Ausgang des Linearverstärkers zu liefern. Dieser Strom wird in Rückkopplung auf der Basis des auf der Höhe der Last gemessenen Stroms gesteuert. Die Last am Ausgang des Verstärkers kann aus dem in Betrieb zu setzenden Elektromotor gebildet sein. Somit hängt die im Motor erzeugte Kraft vom Strom, der die Last durchfließt, ab, die teilweise resistiv und induktiv sein kann. Außerdem kann die Last eine durch den Motor selbst induzierte Spannung umfassen, die zur Verlagerungsgeschwindigkeit proportional ist.

Ein herkömmlicher Leistungslinearverstärker, der mit einer Versorgungsgleichspannungsquelle verbunden ist, verschwendet im Allgemeinen viel Wärmeleistung. Dies kommt von der Tatsache, dass die Ausgangsstufe den ganzen Spannungsabfall zwischen der Spannung von einem der Anschlüsse der Versorgungsspannungsquelle und der Spannung auf der Höhe der vom starken Strom durchflossenen Last verkraften muss. Einer der Leistungstransistoren der Ausgangsstufe wird insbesondere von diesem starken Strom durchflossen. Diese Spannungsdifferenz multipliziert mit dem Strom durch die Last ergibt den gesamten Leistungsverlust des Linearverstärkers.

Wenn als Beispiel eine Versorgungsgleichspannung in der Größenordnung von 48 V und eine Spannung an der Last nahe 20 V mit einem Strom von 20 A betrachtet wird, kann die von einem der Leistungstransistoren der Ausgangsstufe verschwendete Leistung in der Größenordnung von 560 W liegen. Deshalb erhitzt sich die Ausgangsstufe eines derartigen Leistungslinearverstärkers enorm. Folglich ist es erforderlich, dass eine elektronische Schaltung, die einen derartigen Leistungslinearverstärker umfasst, entworfen wird, um am wenigsten Wärmeenergie zu verschwenden, da sie ein Gerät ausstatten kann, das an Orten angeordnet ist, an denen die Temperatur gut gesteuert werden muss. Im Fall, dass ein Leistungslinearverstärker ein Gerät ausstattet, das beispielsweise in einem Reinraum für Verfahren zur Herstellung von integrierten Schaltungen angeordnet ist, ist es erforderlich, die ganze Wärmeverlustleistung zu verringern, um nicht einen derartigen Reinraum mit einer großen Klimaanlage versehen zu müssen.

Um das Problem der hohen Wärmeverlustleistung einer derartigen elektronischen Schaltung zu lösen, kann der herkömmliche Leistungslinearverstärker vorteilhafterweise mit einem Schaltbetriebsverstärker oder einer Schaltbetriebs-Verstärkungseinheit parallel geschaltet werden. In diesem Fall verläuft der Hauptteil des Stroms, der die Last durchfließt, durch den Schaltbetriebsverstärker anstelle der Ausgangsstufe des Linearverstärkers. Im Prinzip liegt der Mittelwert des Stroms am Ausgang des Linearverstärkers, sobald er stabilisiert ist, nahe 0 A. Eine Restwärmeverlustleistung wird trotzdem bei dem Leistungslinearverstärker festgestellt, da der momentane Wert des Stroms nicht null ist. Durch eine elektronische Schaltung mit einem durch einen Schaltbetriebsverstärker unterstützten Linearverstärker, wird die Wärmeverlustleistung stark verringert.

Die US 2002/0089316 A1 zeigt ein erstes Beispiel für einen durch einen Schaltbetriebsverstärker unterstützten Linearverstärker, der durch eine besondere Ansteuerung mit drei unterschiedlichen Arbeitsbereichen besonders energiesparend arbeitet.

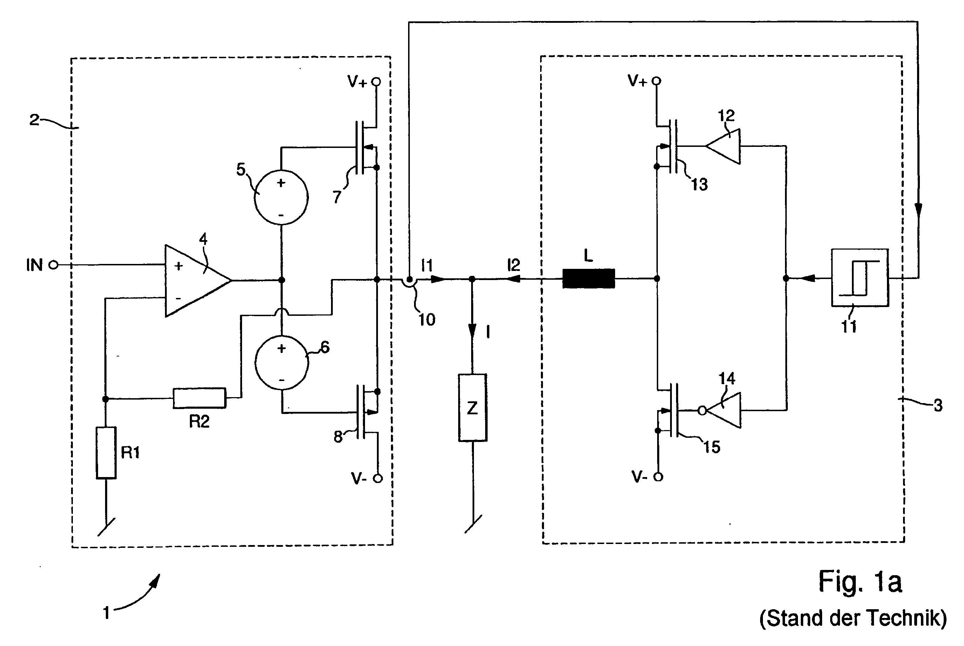

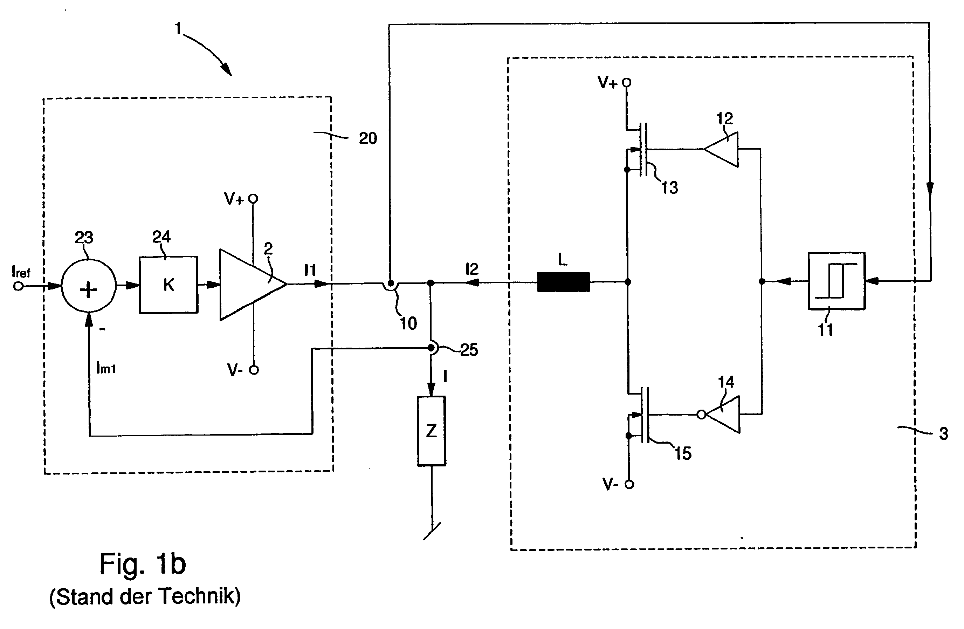

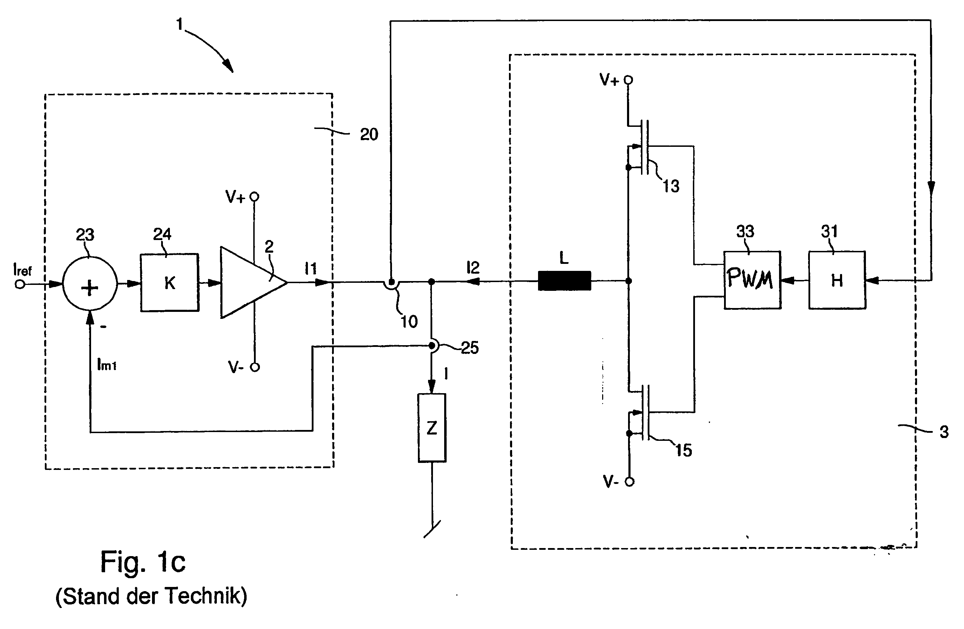

Dazu kann der von Hans Ertl, Johann W. Kolar und Franz C. Zach abgefasste Artikel mit dem Titel "Basic considerations and topologies of switched-mode assisted linear power amplifiers", veröffentlicht im Journal IEEE Transactions on Industrial Electronics, Spalte 44, Nr. 1, vom Februar 1997, zitiert werden. Die elektronische Schaltung mit einem durch eine Schaltbetriebs-Verstärkungseinheit unterstützten Linearverstärker von diesem Artikel ist insbesondere in Fig. 1 a dargestellt.

Die elektronische Schaltung 1 von Fig. 1 a umfasst folglich hauptsächlich einen Leistungslinearverstärker 2 und eine Schaltbetriebs-Verstärkungseinheit 3. Der Leistungslinearverstärker 2 umfasst einen Operationsverstärker 4, dessen nicht invertierender Eingangsanschluss eine Sollspannung IN empfängt, um die an die Last Z am Ausgang angelegte Spannung zu bestimmen. Ein Widerstandsteiler, der zwei Widerstände R1 und R2 umfasst, ist mit der Last Z am Ausgang des Linearverstärkers 2 und mit einer Referenzspannung, die vorzugsweise auf 0 V liegt, wie ein Masseanschluss, verbunden. Der Verbindungsknoten der zwei Widerstände R1 und R2 ist mit dem invertierenden Eingangsanschluss des Operationsverstärkers 4 verbunden, um die an die Last Z angelegte Spannung in Abhängigkeit von der Sollspannung IN zu regeln. Die Widerstände R1 und R2 können ein und denselben Widerstandswert aufweisen, der insbesondere viel größer ist als der Widerstandswert der Last Z.

Der Leistungslinearverstärker 2 umfasst noch zwei Leistungstransistoren des MOSFET-Typs 7 und 8, die zwischen zwei Anschlüssen V+ und V- einer nicht dargestellten Versorgungsgleichspannungsquelle in Reihe geschaltet sind. Das hohe Potential V+ der Versorgungsspannungsquelle kann beispielsweise in der Größenordnung von 24 V liegen, während das niedrige Potential V- der Versorgungsspannungsquelle beispielsweise in der Größenordnung von -24 V liegen kann. Der Drain des ersten MOSFET-Transistors vom N-Typ 7 ist mit dem Anschluss mit hohem Potential V+ der Versorgungsspannungsquelle verbunden und sein Source ist mit dem Source des zweiten MOSFET-Transistors vom P-Typ 8 und mit der Last Z verbunden. Der Drain des zweiten MOSFET-Transistors vom P-Typ 8 ist mit dem Anschluss mit niedrigen Potential V- der Versorgungsspannungsquelle verbunden. Die Gates des ersten und des zweiten Leistungstransistors 7 und 8 sind über eine erste Spannungsquelle 5 bzw. eine zweite Spannungsquelle 6 mit dem Ausgang des Operationsverstärkers 4 verbunden. Jede Spannungsquelle wird hauptsächlich verwendet, um das Gate des entsprechenden Leistungstransistors, dessen Leitungsschwellenspannung größer als 5 V sein kann, auf einen geeigneten Pegel zu polarisieren. In gut bekannter Weise ermöglicht es folglich jede Spannungsquelle 5 und 6, eine schnellere Leitung des entsprechenden Leistungstransistors 7 und 8 in Abhängigkeit von einer Spannungsschwankung am Ausgang des Operationsverstärkers 4 zu bewirken.

Jeder MOSFET-Leistungstransistor 7 und 8 in der Ausgangsstufe wird in Abhängigkeit vom Strom I1, der am Ausgang des Linearverstärkers 2 zur Last Z geliefert wird, in den leitenden Zustand versetzt. Im Fall eines Stroms I1 mit positivem Wert wird der erste Leistungstransistor 7 in den leitenden Zustand versetzt, während im Fall, dass dieser Strom I1 einen negativen Wert aufweist, der zweite Leistungstransistor 8 in den leitenden Zustand versetzt wird.

Der vorstehend beschriebene Stand der Technik umfasst auch den Betrieb einer Schaltbetriebs-Verstärkungseinheit 3, die einen Strom I2 zur Last Z mit einer gewissen Verzögerung in Bezug auf den Betrieb des Linearverstärkers 2 liefert, wie nachstehend erläutert. Die Addition der zwei Ströme I1 und I2 entspricht dem Strom I, der die Last Z durchfließt.

Die Schaltbetriebs-Verstärkungseinheit 3 der elektronischen Schaltung 1 von Fig. 1a umfasst einen Hystereseregler 11, der einen Wert des Stroms I1 empfängt, der durch einen Stromsensor 10 am Ausgang des Leistungslinearverstärkers 2 gemessen wird. Dieser Hystereseregler 11 liefert ein Steuersignal zu einem Durchlassglied 12, das mit dem Gate eines ersten MOSFET-Leistungstransistors vom N-Typ 13 verbunden ist, und zu einem Inverter 14, der mit dem Gate eines zweiten MOSFET-Leistungstransistors vom N-Typ 15 verbunden ist. Der Drain des ersten MOSFET-Leistungstransistors vom N-Typ 13 ist mit dem Anschluss mit hohem Potential V+ der Versorgungsspannungsquelle verbunden, während der Source des zweiten MOSFET-Leistungstransistors vom N-Typ 15 mit dem Anschluss mit niedrigem Potential V- der Versorgungsspannungsquelle verbunden ist. Der Source des ersten Transistors 13 und der Drain des zweiten Transistors 15 sind mit einer Induktivität L verbunden, die ihrerseits mit der Last Z verbunden ist, um den Strom 12 zu liefern.

Der Spannungspegel des Steuersignals am Ausgang des Hysteresereglers ermöglicht es, abwechselnd und zyklisch entweder den ersten Leistungstransistor 13 oder den zweiten Leistungstransistor 15 in den leitenden Zustand zu versetzen. Sobald der vom Sensor 10 gemessene Strom I1 einen ersten Schwellenwert des Hysteresereglers erreicht, wird eine Umschaltung der Leitung der Leistungstransistoren 13 und 15 bewirkt. Die Umschaltung der Leitung der Leistungstransistoren modifiziert umgekehrt die Zunahme oder die Abnahme des Stroms 12, der durch die Schaltbetriebs-Verstärkungseinheit über die Induktivität L geliefert wird. In Abhängigkeit von der Zunahme oder der Abnahme des Stroms I2 in Bezug auf die Umschaltung der Leistungstransistoren 13 und 15 nimmt der Strom 11 bis zu einem zweiten Schwellenwert des Hysteresereglers 11 ab oder zu. Die Addition der Ströme I1 und I2 modifiziert im Prinzip nicht den definierten Strom I, der durch die Last Z fließt, da die an die Anschlüsse der Last angelegte Spannung durch den Linearverstärker 2 gesteuert wird. Sobald der durch den Sensor 10 gemessene Strom 11 den zweiten Schwellenwert des Hysteresereglers 11 erreicht, tritt eine neue Umschaltung der Leitung der Leistungstransistoren 13 und 15 ein. Eine Wiederholung der Umschaltung der Leistungstransistoren 13 und 15 erfolgt in der Zeit und zyklisch gemäß einer Umschaltperiode T. Dies erzeugt eine Welligkeit der Ströme I1 und I2. Der Mittelwert des Stroms 11 liegt dagegen nahe 0 A, sobald er stabilisiert ist.

Eine elektronische Schaltung mit einem durch eine Schaltbetriebseinheit unterstützten Linearverstärker mit einer Struktur, die im Wesentlichen zu jener der elektronischen Schaltung von Fig. 1 a identisch ist, ist in dem von Geoffrey R. Walker verfassten Artikel mit dem Titel "A Class B Switch-Mode Assisted Linear Amplifier", veröffentlicht im Journal IEEE Transactions on power electronics, Spalte 18, Nr. 6, vom November 2003, beschrieben. Der wesentliche Unterschied dieser elektronischen Schaltung besteht darin, dass eine Messung des Stroms I1 durch einen ersten Sensor auf der Höhe des Drains des ersten Leistungstransistors der Ausgangsstufe des Linearverstärkers und durch einen zweiten Sensor auf der Höhe des Drain des zweiten Leistungstransistors bewirkt wird. Ein erster Hystereseregler der Schaltbetriebseinheit empfängt den Wert des Stroms 11 des ersten Sensors, während ein zweiter Hystereseregler den Wert des Stroms I1 des zweiten Sensors empfängt. Das Prinzip der Umschaltung der Leistungstransistoren der Schaltbetriebseinheit ist dagegen zu jenem, das mit Bezug auf Fig. 1 a beschrieben wurde, identisch. Deshalb hat diese elektronische Schaltung dieselben Nachteile wie die elektronische Schaltung von Fig. 1 a.

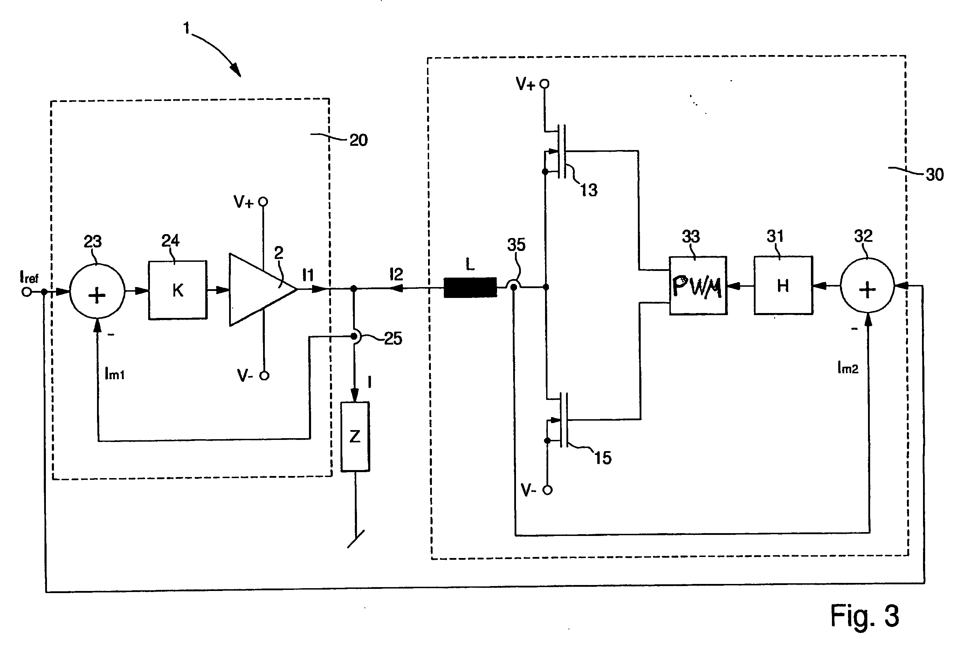

Für die Motorsteuerung ist es erwünscht, den Strom zu regeln, der in der Last strömt. Dazu wird typischerweise ein Regler vom Proportional-Integral-Typ (PI-Typ) verwendet, der im Stand der Technik gut bekannt ist. Dazu kann der von R. Pastorino, M.A. Naya, J.A. Perez und J. Cuadrado verfasste Artikel mit dem Titel "X-by-wire vehicle prototype: A steer-by-wire system with geared PM coreless motors", veröffentlicht auf der 7. Konferenz "EUROMECH Solid Mechanics" in Lissabon, Portugal, im September 2009, zitiert werden. Fig. 3 dieses Artikels zeigt ein Beispiel zur Stromregelung mittels eines Linearverstärkers und eines PI-Reglers, deren Funktion im Absatz 3.1.1. ausführlich beschrieben ist.

Fig. 1b zeigt eine verbesserte Ausführung der elektronischen Schaltung 1, die in Fig. 1a dargestellt ist, in der der Strom in der Last geregelt wird. Die Linearverstärkereinheit 20 umfasst einen ersten Stromregelkreis. Die Linearverstärkereinheit 20 umfasst zuallererst ein erstes Subtrahierglied 23 des ersten Stromregelkreises. In diesem Subtrahierglied 23 wird der Strom Iₘ₁, der über der Last Z durch einen ersten Sensor 25 in Reihe mit der Last gemessen wird, vom Referenzstrom Iref subtrahiert, der der Stromsollwert ist. Das Ergebnis der Subtraktion wird zu einem ersten Regler 24 geliefert, der vorzugsweise ein gut bekannter PI-Regler ist. Dieser Regler 24 liefert eine Steuerspannung zu einem Linearverstärker 2, der am Ausgang einen ersten Strom 11 zum Durchfließen der Last Z erzeugt. Der Wert dieses Stroms I1 wird durch die Linearverstärkereinheit 20 in Abhängigkeit vom detektierten Pegel der Spannung an der Last und hauptsächlich von der Messung des Stroms I, der die Last durchfließt, angepasst. Die Schaltbetriebs-Verstärkungseinheit 3 umfasst dagegen dieselben Elemente wie die mit Bezug auf Fig. 1a beschriebenen, wobei eine Messung des Stroms I1 durch den zweiten Sensor 10 am Eingang der Einheit 3 geliefert wird.

Fig. 1c zeigt eine weitere verbesserte Ausführung der in Fig. 1b dargestellten elektronischen Schaltung 1. Der wesentliche Unterschied der elektronischen Schaltung 1 dieser Fig. 1c besteht darin, dass der Hystereseregler durch einen zweiten PI-Regler 31 ersetzt ist. Der Hystereseregler umfasst nämlich gewisse Unzulänglichkeiten, die nachstehend ausführlich beschrieben werden, und es ist wünschenswert, ihn durch einen PI-Regler zu ersetzen, der mit einem Impulsbreitenmodulator (PWM) 33 in Reihe geschaltet ist, der das Gate der Leistungstransistoren 13 und 15 steuert. Der Betrieb eines derartigen Modulators 33 ist dem Fachmann gut bekannt und ist beispielsweise in Fig. 3 des Patents US 7 385 363 dargestellt. Folglich wird keine detaillierte Information hinsichtlich seines internen Betriebs gegeben. Der Modulator dieses Patents ermöglicht das Umschalten der Leistungstransistoren 13 und 15 mit konstanter Frequenz, was beim Hystereseregler der Fig. 1 a und 1 b nicht der Fall ist.

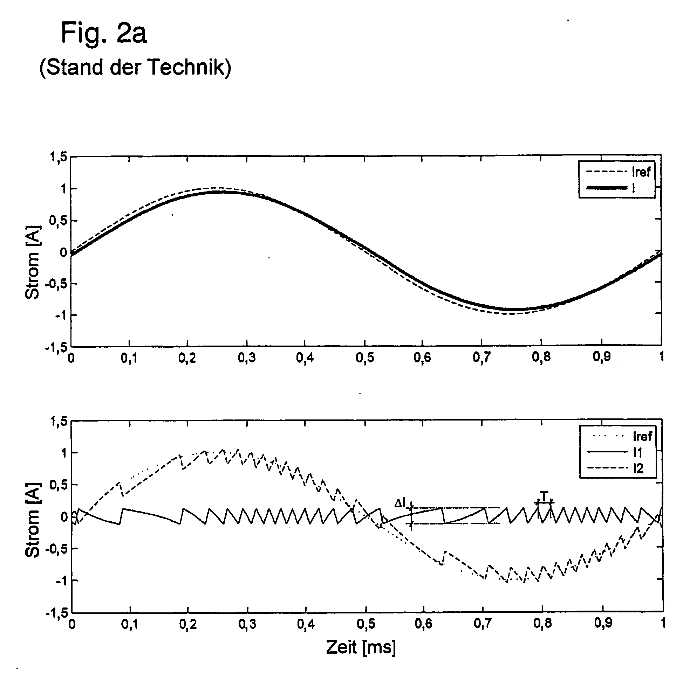

Fig. 2a stellt graphisch die Veränderung der Ströme 11 und 12 in der Zeit in Bezug auf einen Stromsollwert Iref, der anfänglich zur Linearverstärkereinheit 20 der elektronischen Schaltung 1 von Fig. 1 b geliefert wird, dar. Diese elektronische Schaltung umfasst den Hystereseregler 11 in der Schaltbetriebs-Verstärkungseinheit 3. In Abhängigkeit vom Sollwert soll ein Strom Iref die Last am Ausgang der Linearverstärkereinheit und der Schaltbetriebs-Verstärkungseinheit durchfließen. In diesem Beispiel ist der Strom Iref sinusförmig mit einer Frequenz von 1 kHz und einer Amplitude von 1 A definiert.

Im Graphen des oberen Teils von Fig. 2a ist festzustellen, dass der Strom in der Last I ziemlich getreu dem Sollwert Iref folgt. Die beobachtete Phasenverschiebung sowie die geringfügige Verminderung der Amplitude sind mit dem Durchlassbereich der Regelung des Stroms der Linearverstärkereinheit verbunden. Dieser Gesamtstrom ist jedoch die Summe des Stroms 11, der von der Linearverstärkereinheit geliefert wird, und des Stroms 12, der von der Schaltbetriebs-Verstärkungseinheit stammt. Die Form dieser Ströme ist im Graphen des unteren Teils von Fig. 2a ausführlich dargestellt.

Sobald der Strom 11 unter 0 A fällt, bis zu einem ersten Schwellenwert des Hysteresereglers, wird eine Umschaltung der Leitung der Leistungstransistoren in der Schaltbetriebseinheit bewirkt. Im Anschluss an das Umschalten nimmt der Strom 12 ab, während der Strom 11 bis zum zweiten Schwellenwert des Hysteresereglers zunimmt, um ein neues Umschalten der Leistungstransistoren der Schaltbetriebseinheit zu bewirken. Der Abstand zwischen dem ersten Schwellenwert und dem zweiten Schwellenwert des Reglers stellt einen Stromabstand ΔI dar, der eingestellt werden kann. Das Umschalten der Leistungstransistoren der Schaltbetriebseinheit wiederholt sich zyklisch gemäß einer Umschaltperiode T.

Da der Strom 11 am Ausgang des Linearverstärkers nicht null ist, besteht noch eine Restverlustleistung im Linearverstärker, was einen Nachteil bildet. Je geringer der Stromabstand ΔI des Hysteresereglers ist, desto größer ist die Umschaltfrequenz der Leistungstransistoren in der Schaltbetriebseinheit, was die Tendenz hat, die Verluste durch Umschalten der elektronischen Schaltung zu steigern. Durch Erhöhen des Stromabstandes ΔI des Hysteresereglers ist dagegen das Umschalten weniger häufig, während die Umschaltperiode T verlängert und mehr Wärme vom Linearverstärker verschwendet wird. In Abhängigkeit vom Wert des Stromsollwerts, der am Eingang der Linearverstärkereinheit geliefert wird, von den Sollwertvariationen und den Variationen der Spannung, die im Motor induziert wird, variiert außerdem die Umschaltperiode T, was ein Nachteil ist. Diese Frequenzvariation ist auf der Kurve in Abhängigkeit von der Zeit gut sichtbar und kann insbesondere zu Problemen der elektromagnetischen Kompatibilität in der Schaltung führen.

Für die Verwirklichung einer guten elektronischen Schaltung muss folglich ein Kompromiss zwischen der Hysterese und der Wärmeverlustleistung sowie ein dynamischer Kompromiss in Bezug auf den Durchlassbereich der Schaltbetriebs-Verstärkungseinheit und die Wärmeverlustleistung gesucht werden. Mit einer elektronischen Schaltung, wie in Fig. 1a oder 1b dargestellt, kann der Rauschabstand normalerweise niemals größer als 80 dB sein, was nachteilig ist. In diesem Beispiel ist der quadratische Mittelwert RMS (Root-Mean-Square in der englischen Terminologie) des Reststroms 11 70,3 mA. Dieser Strom ermöglicht es, die Wärmeverlustleistung im Linearverstärker abzuschätzen.

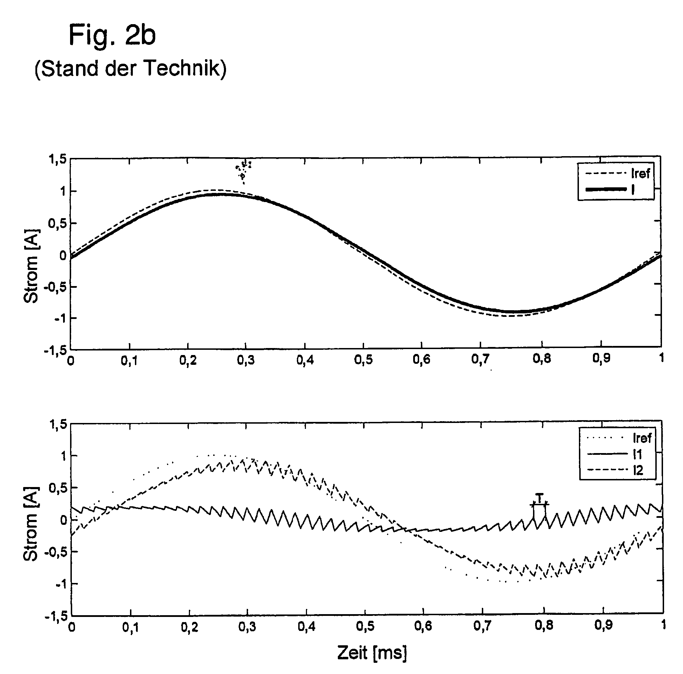

Fig. 2b stellt graphisch die Veränderung der mit der elektronischen Schaltung von Fig. 1c erhaltenen Ströme dar, in der der Hystereseregler durch einen PI-Regler 31 ersetzt ist, der mit einem PWM-Modulator 33 in Reihe geschaltet ist. Im Graphen des oberen Teils von Fig. 2b ist festzustellen, dass der Gang des Stroms in der Last I zu jenem von Fig. 2a identisch ist. Der Gesamtstrom I hängt nämlich nur von der Regelung ab, die in der Linearverstärkereinheit 20 durchgeführt wird.

Im Graphen des unteren Teils von Fig. 2b ist festzustellen, dass die Umschaltperiode T durch die Verwendung des PWM-Modulators 33 konstant ist, was ein Vorteil ist. Dagegen hat der Reststrom 11 im Vergleich zu jenem von Fig. 2a zugenommen. Sein quadratischer Mittelwert (RMS) ist nämlich jetzt 138,6 mA. Dies liegt an der Phasenverzögerung zwischen Iref und I1 aufgrund der Unvollkommenheit der in der Linearverstärkereinheit 20 durchgeführten Regelung. Eine zweite Phasenverzögerung wird durch den PI-Regler 31 eingeführt. Der Reststrom umfasst folglich eine sinusförmige Komponente, die in Fig. 2b gut sichtbar ist, zusätzlich zu den Welligkeiten, die mit dem Umschalten der Schaltbetriebseinheit verbunden sind.

Die Erfindung hat folglich das Ziel, eine elektronische Schaltung mit einem durch eine Schaltbetriebs-Verstärkungseinheit unterstützten Linearverstärker zu liefern, die eine hohe Wirksamkeit mit einem guten Rauschabstand und eine geringe Wärmeverlustleistung des Linearverstärkers aufweist, während die vorstehend erwähnten Nachteile des Standes der Technik beseitigt werden.

Dazu betrifft die Erfindung eine elektronische Schaltung mit einem durch eine Schaltbetriebs-Verstärkungseinheit unterstützten Linearverstärker, die die im unabhängigen Anspruch 1 erwähnten Merkmale umfasst.

Spezielle Ausführungsformen der elektronischen Schaltung sind in den abhängigen Ansprüchen 2 bis 11 definiert.

Ein Vorteil der elektronischen Schaltung der vorliegenden Erfindung liegt in der Tatsache, dass beim Betrieb der elektronischen Schaltung ein Stromsollwert gleichzeitig sowohl zur Linearverstärkereinheit als auch zur Schaltbetriebs-Verstärkungseinheit geliefert wird. Dies ermöglicht der Schaltbetriebs-Verstärkungseinheit, schnell einen Strom zur Last zu liefern, was möglichst schnell den Strom im Absolutwert abnehmen lässt, der durch die Ausgangsstufe des Linearverstärkers zur Last geliefert wird. Deshalb wird eine geringere Wärmeverlustleistung des Linearverstärkers in Bezug auf eine elektronische Schaltung des Standes der Technik erhalten.

Ein weiterer Vorteil der elektronischen Schaltung der vorliegenden Erfindung liegt in der Tatsache, dass sich die Induktivität der Schaltbetriebs-Verstärkungseinheit nicht im Regelkreis des Stroms, der von der Einheit erzeugt wird, befindet. Dies ermöglicht, dass der Regler der Schaltbetriebs-Verstärkungseinheit an eine hohe Bandbreite angepasst wird, da sich die Induktivität nicht mehr im Inneren des Kreises befindet. Außerdem sind die Stromregelkreise für die Linearverstärkereinheit und für die Schaltbetriebs-Verstärkungseinheit getrennt, um eine bessere Bandbreite an der Schaltbetriebs-Verstärkungseinheit zu erhalten.

Vorteilhafterweise ist jeder Regler der Linearverstärkereinheit und der Schaltbetriebs-Verstärkungseinheit ein PI-Regler anstelle eines Hysteresereglers, der im Allgemeinen nicht erwünscht ist. Ein derartiger PI-Regler, der mit einem PWM-Modulator in Reihe geschaltet ist, hängt nicht vom Wert des Stromsollwerts ab und deshalb variiert die Umschaltfrequenz nicht mit einer Änderung des Werts des Sollwerts. Dies schafft auch den Vorteil der leichteren Wahl der Induktivität L.

Die Ziele, Vorteile und Merkmale der elektronischen Schaltung mit einem durch eine Schaltbetriebs-Verstärkungseinheit unterstützten Linearverstärker zeigen sich besser in der folgenden Beschreibung auf der Basis mindestens einer nicht begrenzenden Ausführungsform, die durch die Zeichnungen dargestellt ist, in denen:
- Fig. 1a,: die bereits angeführt wurde, eine elektronische Schaltung mit einem durch eine Schaltbetriebs-Verstärkungseinheit unterstützten Linearverstärker des Standes der Technik darstellt,
- Fig. 1b,: die bereits angeführt wurde, eine Variante der elektronischen Schaltung mit Linearverstärker von Fig. 1a darstellt, deren Strom geregelt wird,
- Fig. 1c,: die bereits angeführt wurde, eine Variante der elektronischen Schaltung mit Linearverstärker von Fig. 1 b darstellt, deren Regelung des Stroms in der Schaltbetriebs-Verstärkungseinheit durch einen PI-Regler durchgeführt wird,
- Fig. 2a,: die bereits angeführt wurde, eine Graphik der Veränderung der Ströme am Ausgang der Linearverstärkereinheit und der Schaltbetriebs-Verstärkungseinheit der elektronischen Schaltung des Standes der Technik, die in Fig. 1b gezeigt ist, darstellt,
- Fig. 2b,: die bereits angeführt wurde, eine Graphik der Veränderung der Ströme am Ausgang der Linearverstärkereinheit und der Schaltbetriebs-Verstärkungseinheit der elektronischen Schaltung des Standes der Technik, die in Fig. 1c gezeigt ist, darstellt,
- Fig. 3: in vereinfachter Weise eine Ausführungsform einer elektronischen Schaltung mit einem durch eine Schaltbetriebs-Verstärkungseinheit unterstützten Linearverstärker gemäß der Erfindung darstellt, und
- Fig. 4: eine Vergleichsgraphik der Veränderung der Ausgangsströme der Linearverstärkereinheit und der Schaltbetriebs-Verstärkungseinheit der elektronischen Schaltung gemäß der Erfindung in Abhängigkeit von einem gelieferten Stromsollwert darstellt.

In der folgenden Beschreibung werden alle Teile der elektronischen Schaltung, die einem Fachmann auf diesem technischen Gebiet gut bekannt sind, nur in vereinfachter Weise beschrieben. Eine derartige elektronische Schaltung kann hauptsächlich für die Steuerung eines Elektromotors mit Nanometerpositionierung beispielsweise für den Bereich der Halbleiterfertigung verwendet werden. Es kann sich um einen Linearmotor handeln, bei dem eine Positionsregelung mittels dieser elektronischen Schaltung durchgeführt wird, die den Motor steuert. Eine derartige elektronische Schaltung kann natürlich auch in elektrischen Geräten für andere technische Gebiete verwendet werden.

Fig. 3 stellt eine elektronische Schaltung 1 dar, die beispielsweise für die Steuerung eines Elektromotors, wie eines Linearmotors, der eine Nanometerpositionierung garantieren kann, verwendet werden kann. Die elektronische Schaltung 1 umfasst hauptsächlich eine Linearverstärkereinheit 20 und eine Schaltbetriebs-Verstärkungseinheit 30, um die Linearverstärkereinheit 20 zu unterstützen. Bei einem Betrieb der elektronischen Schaltung 1 wird ein Referenzstrom Iref, der ein Stromsollwert ist, gleichzeitig zur Linearverstärkereinheit 20 und zur Schaltbetriebs-Verstärkungseinheit 30 geliefert. Mit diesem Stromsollwert wird die Last Z, die am Ausgang der Einheiten angeschlossen ist und die der zu steuernde Elektromotor sein kann, durch einen bestimmten gewünschten Strom I durchflossen. Eine Stromregelung wird folglich in den zwei Einheiten bewirkt, um einen bestimmten Strom I über der Last Z, der vom angelegten Wert des Stromsollwerts Iref abhängt, aufrechtzuerhalten. Der Referenzstrom Iref kann konstant sein, aber er kann sich auch im Verlauf der Zeit ändern, um den Wert des Stroms I, der die Last Z durchfließt, zu modifizieren, oder an die elektronische Schaltung 1 in spezifizierten Zeitperioden angelegt werden. Für die Steuerung eines Motors wird typischerweise ein sinusförmiger Sollwert Iref verwendet, der mit der Position des Motors synchronisiert ist.

Die Linearverstärkereinheit 20 umfasst einen ersten Stromregelkreis. Die Linearverstärkereinheit 20 umfasst zuallererst ein erstes Subtrahierglied 23 des ersten Stromregelkreises. In diesem Subtrahierglied 23 wird der Strom Iₘ₁, der über der Last Z durch einen ersten Sensor 25 in Reihe mit der Last gemessen wird, vom Referenzstrom Iref subtrahiert, der der Stromsollwert ist. Das Ergebnis der Subtraktion wird zu einem ersten Regler 24 geliefert, der vorzugsweise ein gut bekannter Proportional-Integral-Regler ist. Dieser Regler 24 liefert eine Steuerspannung zu einem Linearverstärker 2, der am Ausgang einen ersten Strom 11 zum Durchfließen der Last Z erzeugt. Der Wert dieses Stroms 11 wird durch die Linearverstärkereinheit 20 in Abhängigkeit vom detektierten Pegel der Spannung an der Last und hauptsächlich von der Messung des Stroms I, der die Last durchfließt, angepasst.

Die Struktur des Linearverstärkers 2 der Linearverstärkereinheit 20 kann zu der mit Bezug auf Fig. 1 a dargestellten identisch sein. Der nicht invertierende Eingang dieses Linearverstärkers wird jedoch durch die durch den PI-Regler 24 gelieferte Steuerspannung gesteuert. Diese Steuerspannung ändert sich in Abhängigkeit vom Ergebnis der Subtraktion der Ströme im ersten Subtrahierglied 23, das zum Regler 24 geliefert wird. Dieser Linearverstärker 2 ist mit einem Anschluss mit niedrigem Potential V- und mit einem Anschluss mit hohem Potential V+ einer Versorgungsgleichspannungsquelle, die nicht dargestellt ist, verbunden. Das niedrige Potential dieser Spannungsquelle kann beispielsweise -24 V betragen, während das hohe Potential dieser Spannungsquelle beispielsweise 24 V betragen kann. Deshalb erfordert dies das Verringern des vom Linearverstärker 2 gelieferten ersten Stroms I1 auf das Minimum, um die Wärmeverlustleistung der elektronischen Schaltung zu verringern, wie vorstehend erläutert. Der Mittelwert des Stroms 11 muss im Prinzip nahe 0 A liegen, sobald die elektronische Schaltung durch die Schaltbetriebs-Verstärkungseinheit 30, die die Linearverstärkereinheit 20 unterstützt, stabilisiert ist.

Die Schaltbetriebs-Verstärkungseinheit 30 umfasst einen zweiten Stromregelkreis, der vom ersten Stromregelkreis der Linearverstärkereinheit 20 unabhängig ist. Die Schaltbetriebs-Verstärkungseinheit 30 umfasst zuallererst ein zweites Subtrahierglied 32 des zweiten Stromregelkreises. In diesem zweiten Subtrahierglied 32 wird der Strom Iₘ₂, der durch einen zweiten Sensor 35 gemessen wird, der vor einer Ausgangsinduktivität L in Reihe angeordnet ist, vom Referenzstrom Iref subtrahiert, der der Stromsollwert ist. Das Ergebnis der Subtraktion wird zu einem zweiten Regler 31 geliefert, der vorzugsweise auch ein gut bekannter PI-Regler ist. Dieser zweite Regler 31 liefert eine Steuerspannung zu einem PWM-Modulator 33, der mit dem Gate eines ersten MOSFET-Leistungstransistors vom N-Typ 13 und mit einem zweiten MOSFET-Leistungstransistor vom N-Typ 15 verbunden ist. Der Drain des ersten MOSFET-Leistungstransistors vom N-Typ 13 ist mit dem Anschluss mit hohem Potential V+ der Versorgungsspannungsquelle verbunden, während der Source des zweiten MOSFET-Leistungstransistors vom N-Typ 15 mit dem Anschluss mit niedrigem Potential V- der Versorgungsspannungsquelle verbunden ist. Der Source des ersten Transistors 13 und der Drain des zweiten Transistors 15 sind mit einer Induktivität L über den zweiten Stromsensor 35 verbunden. Das andere Ende dieser Induktivität L ist mit der Last Z verbunden, um den Strom I2 zu liefern.

Es ist zu beachten, dass der erste und der zweite Leistungstransistor 13 und 15 einen ersten und einen zweiten Schalter bilden. Dieser erste und zweite Schalter können auch mit anderen Typen von Transistoren, wie MOSFET-Transistoren vom P-Typ oder bipolaren Leistungstransistoren vom NPN-Typ und/oder PNP-Typ, sogar IGBT, verwirklicht werden. Außerdem kann jeder Stromsensor 25 und 35 ein Sensor vom Nebenschlusstyp (Widerstand) oder ein Magnetflusssensor (Hall-Sonde) sein. Dennoch können andere Sensortypen für die Messung des Stroms in jedem Stromregelkreis erdacht werden.

Der PWM-Modulator 33 ermöglicht es, abwechselnd und zyklisch entweder den ersten Leistungstransistor 13 oder den zweiten Leistungstransistor 15 leitend zu machen. Ein Umschalten der Leitung der Leistungstransistoren 13 und 15 hängt vom Ausgangssignal des PI-Reglers 31 ab, das vom Ergebnis der Subtraktion der Ströme im zweiten Subtrahierglied 32 abhängt. Das Umschalten der Leitung der Leistungstransistoren modifiziert umgekehrt die Zunahme oder die Abnahme des durch die Schaltbetriebs-Verstärkungseinheit über die Induktivität L und die Last Z gelieferten Stroms 12. Diese Induktivität L befindet sich vorteilhafterweise nicht im zweiten Stromregelkreis. Dies ermöglicht es, einen besseren Durchlassbereich des Umschaltens der Schaltbetriebs-Verstärkungseinheit in Bezug auf den vorstehend angeführten Stand der Technik zu haben. Der zweite Regler 31 kann somit ohne Bedeutung des Werts der Induktivität L an eine hohe Bandbreite angepasst werden.

Durch die Verwendung von PI-Reglern 24 und 31 und des PWM-Modulators 33 hängt die Umschaltperiode der Leistungstransistoren 13 und 15 nicht vom Stromsollwert Iref, der an die Linearverstärkereinheit 20 und die Schaltbetriebs-Verstärkungseinheit 30 angelegt wird, ab. Dagegen kann die Umschaltperiode im PWM-Modulator 33 angepasst werden. Dies ermöglicht es auch, die Spannungs- oder Stromwelligkeit auf der Höhe der Last Z zu verringern.

Der PI-Regler 24 kann vom analogen Typ sein, der beispielsweise in der Linearverstärkereinheit 20 verwendet werden kann, um über einen Durchlassbereich im ersten Stromregelkreis in der Größenordnung von 1 MHz zu verfügen. Ein derartiger Durchlassbereich ist jedoch theoretisch für kleine Ströme erreichbar, was es erfordert, die Komponenten, die ihn bilden, anzupassen. Vorzugsweise kann es sich um einen digitalen PI-Regler 24 handeln. In diesem Fall kann der Durchlassbereich im ersten Regelkreis zwischen 10 und 50 kHz mit einer größeren Konfigurationsleichtigkeit des Reglers mit Parametern, die in einem dazu vorgesehenen Register gespeichert sind, liegen. Mit einem derartigen digitalen Regler 31 im zweiten Stromregelkreis kann der Durchlassbereich mindestens 1 kHz sein. Es kann z.B. eine Umschaltfrequenz von 20 kHz vorgesehen sein. Die Umschaltparameter der Leistungstransistoren 13 und 15 können somit leicht auch in ein Register des zweiten Reglers 31 programmiert werden.

Wenn Hystereseregler anstelle von PI-Reglern verwendet werden, hängt die Umschaltperiode vom Wert des Stromsollwerts und von der an die Last Z angelegten momentanen Spannung ab. Dies liegt an der Variation der zunehmenden oder abnehmenden Steigung des Stroms 12 zwischen den zwei Umschaltschwellenwerten. Diese Hystereseregler, die auch als "Ein-Aus" bezeichnet werden, reagieren nur, wenn der Fehler einen bestimmten Schwellenwert überschritten hat. Unter diesen Bedingungen ist es bevorzugt, PI-Regler für die elektronische Schaltung 1 der vorliegenden Erfindung zu verwenden. Sie ermöglichen es auch, den Stromabstand für das Umschalten der Leistungstransistoren zu verringern. Eine sehr geringe Spannungs- oder Stromrestwelligkeit wird bei jedem Umschalten auf der Höhe der Last festgestellt, da einerseits der Stromsollwert Iref direkt an die zwei Einheiten angelegt wird und andererseits die Stromregelkreise voneinander unabhängig sind. Die Induktivität L ist auch nicht in jedem Regelkreis enthalten.

Die elektronische Schaltung 1 der vorliegenden Erfindung besitzt einen sehr guten Rauschabstand (SNR), der sogar in der Größenordnung von 100 dB oder mehr liegen kann. Dies stellt im Allgemeinen mehr als 20 dB mehr als bei jeder elektronischen Schaltung des Standes der Technik dar. Eine derartige elektronische Schaltung kann folglich vorteilhafterweise für die Steuerung eines Elektromotors mit Nanometerpositionierung verwendet werden, während eine geringe Wärmeverlustleistung garantiert wird.

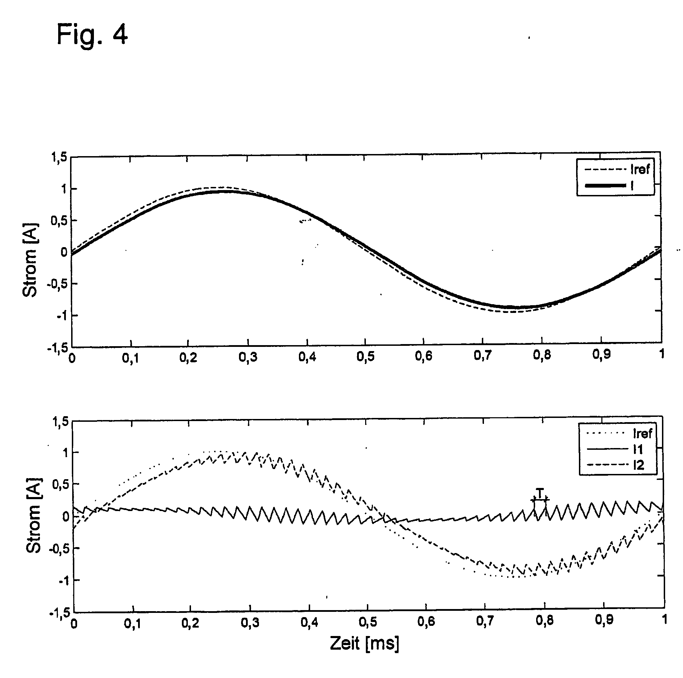

Fig. 4 stellt eine vereinfachte Graphik der Veränderung der Ausgangsströme der Linearverstärkereinheit und der Schaltbetriebs-Verstärkungseinheit der erfindungsgemäßen elektronischen Schaltung dar. Der Graph des oberen Teils von Fig. 4 ist zu jenem von Fig. 2a identisch, da die Stromregelung in der Linearverstärkereinheit nicht modifiziert wurde. Im Graphen des unteren Teils ist dagegen festzustellen, dass die Restwelligkeit des Stroms I1 auf den quadratischen Mittelwert (RMS) von 83,5 mA zurückgebracht wurde. Somit ist festzustellen, dass die elektronische Schaltung der Erfindung die Vorteile eines Umschaltens mit konstanter Frequenz kombiniert, während die Restwelligkeit des Stroms 11 durch einen verbesserten Durchlassbereich der Stromregelung in der Schaltbetriebseinheit minimiert wird.

Wenn die Hysterese eines Hysteresereglers der in Fig. 1 a und 1 b dargestellten elektronischen Schaltung als Beispiel auf +/- 100 mA geregelt wird, geschieht nichts, solange der gemessene Strom 100 mA nicht überschreitet. Durch Vorstellen, dass der Strom 11 am Beginn einen Wert von null aufweist und dass der Anstieg des Stroms 48 V/10 mH = 4800 A/s ist, sind (100 mA)/(4800 A/s) = 21 µs bis zum ersten Umschalten des Hysteresereglers erforderlich. Dies definiert folglich eine klare Verzögerung. Außerdem wird der Anstieg des Stroms 11 durch den Durchlassbereich des ersten Regelkreises der Linearverstärkereinheit beeinflusst. Wenn der erste Kreis einen Durchlassbereich von 20 kHz aufweist, gehen ungefähr 50 µs verloren, während gewartet wird, dass der Strom I1 geregelt wird. Die Regelung des Stroms im zweiten Kreis der Schaltbetriebs-Verstärkungseinheit durch die Messung des Stroms 11 hat typischerweise eine Verzögerung von 50 bis 100 µs in Bezug auf die Erfindung.

Die elektronische Schaltung der Erfindung ermöglicht es, die Schaltbetriebs-Verstärkungseinheit sehr schnell in Betrieb zu nehmen, indem gleichzeitig ein und derselbe Stromsollwert Iref an die zwei Einheiten der Schaltung angelegt wird. Dies ermöglicht es folglich, jegliche vorstehend erwähnte Verzögerung in Bezug auf eine elektronische Schaltung des Standes der Technik zu vermeiden. Da es keinen Schwellenstrom mehr gibt, sind die zwei Einheiten jederzeit aktiv, insbesondere selbst dann, wenn der Stromsollwert gering ist, beispielsweise geringer als 100 mA. Jedoch kann auch momentan die Schaltbetriebs-Verstärkungseinheit deaktiviert werden, wenn beispielsweise das mit der elektronischen Anwendung verbundene Verfahren eine Elektronenkanone oder ein elektronisches Mikroskop umfasst. Jegliches Umschaltrauschen muss dann vermieden werden, da es für das verwendete Verfahren verhängnisvoll ist. Außerdem umfasst die Schaltbetriebseinheit alle Elemente eines Standard-Schaltbetriebsverstärkers auf dem Markt. Folglich kann ein Schaltverstärker zu einem Linearverstärker hinzugefügt werden, der existiert. Um die erhaltenen Leistungen noch zu verbessern, ist es außerdem möglich, Vorsteuerungen zu den zwei Spannungssollwerten am Ausgang der Regler 24 und 31 hinzufügen. Diese Vorsteuerungen können insbesondere von einer Abschätzung der in der Last induzierten Spannung in Abhängigkeit von der Geschwindigkeit des Motors stammen.

Um einen Motor schnell drehen zu lassen, ändert sich der Stromsollwert mit ungefähr 1 kHz. Einige verlorene Watt Leistung werden folglich in der elektronischen Schaltung der vorliegenden Erfindung in Bezug auf den Stand der Technik eingespart.

Anhand der Beschreibung, die gerade gegeben worden ist, können mehrere Varianten der elektronischen Schaltung mit einem durch eine Schaltbetriebs-Verstärkungseinheit unterstützten Linearverstärker durch den Fachmann entworfen werden, ohne vom Umfang der Erfindung, die durch die Ansprüche definiert ist, abzuweichen.

## Patentansprüche

1. Elektronische Schaltung (1) mit einer durch eine Schaltbetriebs-Verstärkungseinheit (30) unterstützten Linearverstärkereinheit (20), **dadurch gekennzeichnet, dass** ein Eingang der Linearverstärkereinheit (20) und ein Eingang der Schaltbetriebs-Verstärkungseinheit (30) so verbunden sind, dass sie gleichzeitig ein und denselben Stromsollwert (Iref) beim Betrieb der elektronischen Schaltung (1) empfangen, um durch Regelung einen bestimmten Strom (I) durch eine Last (Z) zu erzeugen, die so mit einem Ausgang jeder Einheit verbunden ist, dass der Strom (I) der Summe eines ersten Stroms (11) am Ausgang der Linearverstärkereinheit (20) und eines zweiten Stroms (I2) am Ausgang der Schaltbetriebs-Verstärkungseinheit (30) entspricht.

2. Elektronische Schaltung (1) nach Anspruch 1, **dadurch gekennzeichnet, dass** die Schaltbetriebs-Verstärkungseinheit (30) zwei Schalter (13, 15), die so in Reihe geschaltet sind, dass sie zwischen zwei Anschlüssen (V+, V-) einer Versorgungsspannungsquelle verbunden sind, und eine Induktivität (L), die zwischen einem Verbindungsknoten der zwei Schalter und einer Last (Z) am Ausgang der Einheit angeordnet ist, umfasst, wobei die Schalter abwechselnd und abhängig vom Stromsollwert (Iref), der im Betrieb der elektronischen Schaltung (1) zu jeder Einheit geliefert wird, aktiviert werden können, um die Induktivität (L) entweder mit einem hohen Potential oder einem niedrigen Potential einer Versorgungsspannungsquelle zu verbinden.

3. Elektronische Schaltung (1) nach einem der vorangehenden Ansprüche, **dadurch gekennzeichnet, dass** in einer Betriebsart der elektronischen Schaltung mit gleichzeitigem Liefern eines Stromsollwerts (Iref) zu jeder Einheit die Linearverstärkereinheit (20) und die Schaltbetriebs-Verstärkungseinheit (30) jeweils zum Liefern des ersten Stroms (I1) am Ausgang der Linearverstärkereinheit (20) und des zweiten Stroms (12) am Ausgang der Schaltbetriebs-Verstärkungseinheit (30) konfiguriert sind, um den bestimmten Strom (I) über der Last (Z) zu erzeugen, wobei der Mittelwert des ersten Ausgangsstroms (I1) in einem stabilisierten Zustand der elektronischen Schaltung nahe 0 A liegt, während der Mittelwert des zweiten Ausgangsstroms (I2) nahe dem Stromsollwert (Iref) liegt.

4. Elektronische Schaltung (1) nach einem der vorangehenden Ansprüche, **dadurch gekennzeichnet, dass** die Linearverstärkereinheit (20) einen ersten Stromregelkreis mit einem ersten Stromsensor (25) umfasst, der in Reihe mit einer Last (Z) angeordnet ist, die am Ausgang der zwei Einheiten angeschlossen ist, wobei der erste Stromsensor einen ersten gemessenen Strom (Iₘ₁) liefern soll, der mit dem Stromsollwert (Iref) verglichen werden soll, um den ersten Ausgangsstrom (I1) im ersten Regelkreis anzupassen.

5. Elektronische Schaltung (1) nach Anspruch 4, **dadurch gekennzeichnet, dass** die Linearverstärkereinheit (20) ein erstes Subtrahierglied (23) im ersten Stromregelkreis umfasst, um den gemessenen ersten Strom (Iₘ₁) vom Stromsollwert (Iref) zu subtrahieren, wobei das Ergebnis der Subtraktion zu einem ersten Regler (24) geliefert wird, der eine Steuerspannung zu einem Linearverstärker (2) liefert, dessen Ausgangsstufe, die zwischen zwei Anschlüssen (V+, V-) einer Versorgungsspannungsquelle verbunden ist, den ersten Ausgangsstrom (I1) liefert.

6. Elektronische Schaltung (1) nach Anspruch 5, **dadurch gekennzeichnet, dass** der erste Regler (24) ein Proportional-Integral-Regler des analogen Typs oder digitalen Typs ist.

7. Elektronische Schaltung (1) nach einem der Ansprüche 2 bis 4, **dadurch gekennzeichnet, dass** die Schaltbetriebs-Verstärkungseinheit (30) einen zweiten Stromregelkreis mit einem zweiten Stromsensor (35) umfasst, der zwischen dem Verbindungsknoten der Schalter (13, 15) und der Induktivität (L) angeordnet ist, wobei der zweite Stromsensor einen zweiten gemessenen Strom (Iₘ₂) liefern soll, der mit dem Stromsollwert (Iref) verglichen werden soll, um den zweiten Ausgangsstrom (I2) im zweiten Regelkreis anzupassen.

8. Elektronische Schaltung (1) nach Anspruch 7, **dadurch gekennzeichnet, dass** die Schaltbetriebs-Verstärkungseinheit (30) ein zweites Subtrahierglied (32) im zweiten Stromregelkreis umfasst, um den gemessenen zweiten Strom (Iₘ₂) vom Stromsollwert (Iref) zu subtrahieren, wobei das Ergebnis der Subtraktion zu einem zweiten Regler (31) geliefert wird, um abwechselnd die Aktivierung der Schalter (13, 15) zu steuern.

9. Elektronische Schaltung (1) nach Anspruch 8, **dadurch gekennzeichnet, dass** ein Ausgang des zweiten Reglers (31) mit einem Impulsbreitenmodulator (33) verbunden ist, der mit dem ersten Schalter (13) und dem zweiten Schalter (15) verbunden ist.

10. Elektronische Schaltung (1) nach Anspruch 9, **dadurch gekennzeichnet, dass** der erste Schalter ein erster MOSFET-Leistungstransistor vom N-Typ (13) ist, dessen Gate mit dem Impulsbreitenmodulator (33) verbunden ist und dessen Drain mit dem Anschluss mit hohem Potential (V+) einer Versorgungsspannungsquelle verbunden ist, und dass der zweite Schalter ein zweiter MOSFET-Leistungstransistor vom N-Typ (15) ist, dessen Gate mit dem Impulsbreitenmodulator (33) verbunden ist und dessen Source mit dem Anschluss mit niedrigem Potential (V-) der Versorgungsspannungsquelle verbunden ist, wobei der Verbindungsknoten des Source des ersten Leistungstransistors (13) und des Drain des zweiten Leistungstransistors (15) über den zweiten Stromsensor (35) mit der Induktivität (L) verbunden ist.

11. Elektronische Schaltung (1) nach Anspruch 8, **dadurch gekennzeichnet, dass** der zweite Regler (31) mit einem digitalen Impulsbreitenmodulator (33) in Reihe geschaltet ist, der konfigurierbar ist, um die Umschaltperiode (T) der Schalter anzupassen.

## Claims

1. Electronic circuit (1) comprising a linear amplifier unit (20) supported by a switched-mode amplification unit (30), **characterized in that** an input of the linear amplifier unit (20) and an input of the switched-mode amplification unit (30) are connected such that they simultaneously receive one and the same setpoint current value (Iref) during the operation of the electronic circuit (1) in order to generate by control a specific current (I) through a load (Z) connected to an output of each unit such that the current (I) corresponds to the sum of a first current (I1) at the output of the linear amplifier unit (20) and a second current (I2) at the output of the switched-mode amplification unit (30).

2. Electronic circuit (1) according to Claim 1, **characterized in that** the switched-mode amplification unit (30) comprises two switches (13, 15), which are connected in series such that they are connected between two terminals (V+, V-) of a supply voltage source, and an inductance (L) arranged between a connecting node of the two switches and a load (Z) at the output of the unit, wherein the switches can be activated alternately and depending on the setpoint current value (Iref) supplied to each unit during the operation of the electronic circuit (1), in order to connect the inductance (L) either to a high potential or a low potential of a supply voltage source.

3. Electronic circuit (1) according to either of the preceding claims, **characterized in that** in an operating mode of the electronic circuit with simultaneous supply of a setpoint current value (Iref) to each unit, the linear amplifier unit (20) and the switched-mode amplification unit (30) are respectively configured for supplying the first current (I1) at the output of the linear amplifier unit (20) and the second current (12) at the output of the switched-mode amplification unit (30) in order to generate the specific current (I) across the load (Z), wherein the average value of the first output current (I1) in a stabilized state of the electronic circuit is close to 0 A, while the average value of the second output current (12) is close to the setpoint current value (Iref).

4. Electronic circuit (1) according to any of the preceding claims, **characterized in that** the linear amplifier unit (20) comprises a first current control loop with a first current sensor (25), which is arranged in series with a load (Z) connected to the output of the two units, wherein the first current sensor is intended to supply a first measured current (Iₘ₁), which is intended to be compared with the setpoint current value (Iref) in order to adapt the first output current (I1) in the first control loop.

5. Electronic circuit (1) according to Claim 4, **characterized in that** the linear amplifier unit (20) comprises a first subtractor element (23) in the first current control loop in order to subtract the measured first current (Iₘ₁) from the setpoint current value (Iref), wherein the result of the subtraction is supplied to a first controller (24), which supplies a control voltage to a linear amplifier (2), whose output stage connected between two terminals (V+, V-) of a supply voltage source supplies the first output current (I1).

6. Electronic circuit (1) according to Claim 5, **characterized in that** the first controller (24) is a proportional-integral controller of the analogue type or digital type.

7. Electronic circuit (1) according to any of Claims 2 to 4, **characterized in that** the switched-mode amplification unit (30) comprises a second current control loop with a second current sensor (35), which is arranged between the connecting node of the switches (13, 15) and the inductance (L), wherein the second current sensor is intended to supply a second measured current (Iₘ₂), which is intended to be compared with the setpoint current value (Iref) in order to adapt the second output current (I2) in the second control loop.

8. Electronic circuit (1) according to Claim 7, **characterized in that** the switched-mode amplification unit (30) comprises a second subtractor element (32) in the second current control loop in order to subtract the measured second current (Iₘ₂) from the setpoint current value (Iref), wherein the result of the subtraction is supplied to a second controller (31) in order to control the activation of the switches (13, 15) alternately.

9. Electronic circuit (1) according to Claim 8, **characterized in that** an output of the second controller (31) is connected to a pulse width modulator (33) connected to the first switch (13) and the second switch (15).

10. Electronic circuit (1) according to Claim 9, **characterized in that** the first switch is a first N-type MOSFET power transistor (13), the gate of which is connected to the pulse width modulator (33) and the drain of which is connected to the terminal having a high potential (V+) of a supply voltage source, and **in that** the second switch is a second N-type MOSFET power transistor (15), the gate of which is connected to the pulse width modulator (33) and the source of which is connected to the terminal having a low potential (V-) of the supply voltage source, wherein the connecting node of the source of the first power transistor (13) and the drain of the second power transistor (15) is connected to the inductance (L) via the second current sensor (35).

11. Electronic circuit (1) according to Claim 8, **characterized in that** the second controller (31) is connected in series with a digital pulse width modulator (33) that is configurable in order to adapt the switch-over period (T) of the switches.

## Revendications

1. Circuit électrique (1) comportant une unité à amplificateur linéaire (20) supportée par une unité d'amplification à découpage (30), **caractérisé en ce qu'**une entrée de l'unité à amplificateur linéaire (20) et une entrée de l'unité d'amplification à découpage (30) sont reliées de manière à ce qu'elles reçoivent simultanément une seule et même valeur théorique du courant (Iref) lors du fonctionnement du circuit électrique (1), afin de générer par régulation un courant déterminé (I) à travers une charge (Z) qui est reliée à une sortie de chaque unité, de manière à ce que le courant (I) corresponde à la somme d'un premier courant (I1) à la sortie de l'unité à amplificateur linéaire (20) et d'un deuxième courant (I2) à la sortie de l'unité d'amplification à découpage (30).

2. Circuit électrique (1) selon la revendication 1, **caractérisé en ce que** l'unité d'amplification à découpage (30) comprend deux commutateurs (13, 15) qui sont connectés en série de manière à ce qu'ils soient reliés entre deux bornes (V+, V-) d'une source de tension d'alimentation, et une inductance (L) qui est disposée entre un noeud de liaison des deux commutateurs et une charge (Z) à la sortie de l'unité, dans lequel les commutateurs peuvent être activés de manière alternée et en fonction de la valeur théorique du courant (Iref) qui est délivré à chaque unité lors du fonctionnement du circuit électrique (1) afin de relier l'inductance (L) soit à un potentiel haut soit à un potentiel bas d'une source de tension d'alimentation.

3. Circuit électrique (1) selon l'une quelconque des revendications précédentes, **caractérisé en ce que**, dans un mode de fonctionnement du circuit électrique dans lequel une valeur théorique du courant (Iref) est délivrée simultanément à chaque unité, l'unité à amplificateur linéaire (20) et l'unité d'amplification à découpage (30) sont respectivement configurées afin de délivrer le premier courant (I1) à la sortie de l'unité à amplificateur linéaire (20) et le deuxième courant (I2) à la sortie de l'unité d'amplification à découpage (30), afin de générer le courant déterminé (I) par l'intermédiaire de la charge (Z), dans lequel la moyenne du premier courant de sortie (I1), dans un état stabilisé du circuit électrique, est proche de 0 A, alors que la moyenne du deuxième courant de sortie (12) est proche de la valeur théorique du courant (Iref).

4. Circuit électrique (1) selon l'une quelconque des revendications précédentes, **caractérisé en ce que** l'unité à amplificateur linéaire (20) comprend un premier circuit de régulation de courant comportant un premier capteur de courant (25) disposé en série avec une charge (Z), qui est connecté à la sortie des deux unités, dans lequel le premier capteur de courant doit délivrer un premier courant mesuré (Iₘ₁) qui doit être comparé à la valeur théorique du courant (Iref) afin d'adapter le premier courant de sortie (I1) dans le premier circuit régulateur.

5. Circuit électrique (1) selon la revendication 4, **caractérisé en ce que** l'unité à amplificateur linéaire (20) comprend un premier élément soustracteur (23) dans le premier circuit de régulation de courant afin de soustraire le premier courant mesuré (Iₘ₁) à la valeur théorique du courant (Iref), dans lequel le résultat de la soustraction est délivré à un premier régulateur (24) qui délivre une tension de commande à un amplificateur linéaire (2) dont l'étage de sortie, qui est relié entre deux bornes (V+, V-) d'une source de tension d'alimentation, délivre le premier courant de sortie (I1).

6. Circuit électrique (1) selon la revendication 5, **caractérisé en ce que** le premier régulateur (24) est un régulateur proportionnel-intégral du type analogique ou du type numérique.

7. Circuit électrique (1) selon l'une quelconque des revendications 2 à 4, **caractérisé en ce que** l'unité d'amplification à découpage (30) comprend un deuxième circuit de régulation de courant comportant un deuxième capteur de courant (35) disposé entre le noeud de liaison des commutateurs (13, 15) et l'inductance (L), dans lequel le deuxième capteur de courant doit délivrer un deuxième courant mesuré (Iₘ₂) qui doit être comparé à la valeur théorique du courant (Iref), afin d'adapter le deuxième courant de sortie (I2) dans le deuxième circuit régulateur.

8. Circuit électrique (1) selon la revendication 7, **caractérisé en ce que** l'unité d'amplification à découpage (30) comprend un deuxième élément soustracteur (32) dans le deuxième circuit de régulation de courant afin de soustraire le deuxième courant mesuré (Iₘ₂) à la valeur théorique du courant (Iref), dans lequel le résultat de la soustraction est délivré à un deuxième régulateur (31) afin de commander alternativement l'activation des commutateurs (13, 15).

9. Circuit électrique (1) selon la revendication 8, **caractérisé en ce qu'**une sortie du deuxième régulateur (31) est reliée à un modulateur d'impulsion en largeur (33) qui est relié au premier commutateur (13) et au deuxième commutateur (15).

10. Circuit électrique (1) selon la revendication 9, **caractérisé en ce que** le premier commutateur est un premier transistor MOSFET de puissance de type N (13) dont la grille est reliée au modulateur d'impulsion en largeur (33) et dont le drain est relié à la borne au potentiel haut (V+) d'une source de tension d'alimentation, et **en ce que** le deuxième commutateur est un deuxième transistor MOSFET de puissance de type N (15) dont la grille est reliée au modulateur d'impulsion en largeur (33) et dont la source est reliée à la borne au potentiel bas (V-) de la source de tension d'alimentation, dans lequel le noeud de liaison de la source du premier transistor de puissance (13) et du drain du deuxième transistor de puissance (15) est relié à l'inductance (L) par l'intermédiaire du deuxième capteur de courant (35).

11. Circuit électrique (1) selon la revendication 8, **caractérisé en ce que** le deuxième régulateur (31) est connecté en série à un modulateur d'impulsion en largeur numérique (33) qui peut être configuré afin d'adapter la période de commutation (T) des commutateurs.
